Europäisches Patentamt

European Patent Office

Office européen des brevets

(11) Veröffentlichungsnummer: **0 499 830 A2**

# EUROPÄISCHE PATENTANMELDUNG

(21) Anmeldenummer: **92101207.6**

(22) Anmeldetag: **25.01.92**

(51) Int. Cl.5: **H01L 21/311, H01L 21/306**

(30) Priorität: **18.02.91 DE 4104881**

(43) Veröffentlichungstag der Anmeldung:
**26.08.92 Patentblatt 92/35**

(84) Benannte Vertragsstaaten:
**DE FR GB IT**

(71) Anmelder: **RIEDEL-DE HAEN AKTIENGESELLSCHAFT
Wunstorfer Strasse 40
W-3016 Seelze 1(DE)**

(72) Erfinder: **Leifels, Joachim
Südfeld 4
W-3007 Gehrden(DE)**
Erfinder: **Sievert, Wolfgang, Dr.
Dresdner Strasse 10
W-3050 Wunstorf-Kolenfeld(DE)**

(74) Vertreter: **Urbach, Hans-Georg, Dr. et al
CASSELLA AKTIENGESELLSCHAFT
Patentabteilung Hanauer Landstrasse 526
W-6000 Frankfurt am Main 60(DE)**

(54) **Ätzlösung für nasschemische Prozesse der Halbleiterherstellung.**

(57) Die vorliegende Erfindung betrifft eine wäßrige Ätzlösung, die Ammoniumfluorid, Flußsäure sowie ein oder mehrere primäre aliphatische Amine mit einer Kettenlänge von 6 bis 18 Kohlenstoffatomen enthält, dadurch gekennzeichnet, daß Ammoniumfluorid in Mengen von 0,1 bis 17,5 Gew.%, Flußsäure in Mengen von 0,1 bis 10 Gew.% und Amin in Mengen von mindestens 10 ppm enthalten sind unter der Voraussetzung, daß Ammoniumfluorid im Überschuß gegenüber Flußsäure vorliegt.

EP 0 499 830 A2

Die vorliegende Erfindung betrifft eine Ätzlösung für naßchemische Prozesse der Halbleiterherstellung, die Ammoniumfluorid, Flußsäure sowie ein primäres aliphatisches Amin enthält.

Zur Herstellung von diskreten oder integrierten elektronischen Bauelementen auf Siliziumbasis werden in den verschiedensten Herstellungsschritten naßchemische Prozesse eingesetzt. Diese lassen sich grob in naßchemische Reinigungsschritte und naßchemische Strukturierungsschritte einteilen.

Bei den Reinigungsschritten, insbesondere aber bei den Strukturierungsschritten ist es außerordentlich wichtig, daß die Oberflächenspannung der Reinigungs- bzw. Ätzflüssigkeit möglichst gering ist und die zu reinigenden bzw. zu ätzenden Oberflächen ausreichend benetzt werden.

Zu ätzende Schichten sind beispielsweise auf Siliziumscheiben aufgebrachte Siliziumdioxidschichten. Zu deren Strukturierung werden fotochemisch aktive organische Schichten (Fotolacke) auf die Siliziumscheiben aufgesponnen und nach Belichtung des Fotolacks durch Entwicklung strukturiert. Diese strukturierten Lackschichten dienen im nachfolgenden Ätzschritt zur Maskierung der Ätzung in den belackten Gebieten, während die freientwickelten Gebiete weggeätzt werden. Die Fotolackstrukturen bilden dabei oft nur 1 $\mu$m breite und 0,5 bis 2 $\mu$m hohe Erhebungen über den Oxidschichten. Beim Eintauchen der Scheibe in die Ätzlösung müssen die in diesen Strukturen haftenden Luftschichten verdrängt werden, da diese die Ätzung maskieren und damit Defekte in den Bauelementen erzeugen würden. Es ist deshalb besonders wesentlich, daß die Ätzlösung die Oberfläche gut benetzt und eine geringe Oberflächenspannung besitzt. Ist nur die Benetzung gut oder nur die Oberflächenspannung erniedrigt, lösen sich die Lufteinschlüsse nicht von der Oberfläche ab.

Weit verbreitete Ätzmittel sind beispielsweise Ammoniumfluorid/Flußsäure-Mischungen, denen zur Verbesserung ihrer Eigenschaften Additive zugegeben werden. Geeignete Additive müssen die Oberflächenspannung auf einen Wert kleiner 30 mN/m herabsetzen und für eine gute Benetzung der zu ätzenden Oberflächen bzw. der die Ätzung maskierenden Fotolackschichten sorgen. Weiter muß das Additiv in der Ätzlösung gut löslich sein und damit deren Stabilität gegenüber Kreislauffiltration gewährleisten. Es darf keine metallischen Verunreinigungen, die über die üblichen Gehalte der Chemikalien in Halbleiterprozessen hinausgehen, enthalten und es darf keine Reaktion mit der zu ätzenden Oberfläche (Chemisorption) zeigen. Bei der Ätzung darf sich das Additiv nicht an der zu ätzenden Grenzfläche abscheiden und schließlich muß es sich nach der Ätzung durch die üblichen Spülprozesse von der Oberfläche wieder entfernen lassen.

Bekannte Additive für Ammoniumfluorid/Flußsäure-Mischungen sind beispielsweise teilweise oder vollständig fluorierte aliphatische Carbonsäuren oder Sulfonsäuren bzw. deren Salze (Shak et al. Semiconductor International, Oktober 1988, Seiten 132-134). Diese Additive verbessern jedoch nicht die Benetzung, so daß kein Einfluß auf das Ablösen der Lufteinschlüsse aus den zu ätzenden Gebieten zu beobachten ist. Außerdem sind sie nicht stabil gegenüber Kreislauffiltration und werden im Filter abgeschieden.

Es ist weiterhin bereits bekannt, als Additive für Ammoniumfluorid/Flußsäure-Mischungen aliphatische primäre Amine zu verwenden. (Kikuyama et al., Microcontamination, April 1989, Seiten 45 - 51).

Ätzlösungen dieser Art enthalten ca. 30 bis 40 Gew.% Ammoniumfluorid, 0,1 bis 10 Gew.% Flußsäure und 200 ppm Amin und weisen sowohl eine reduzierte Oberflächenspannung als auch eine verbesserte Benetzung des Fotolacks auf.

Nachteilig ist jedoch die geringe Löslichkeit der Amine in den genannten Systemen. Daraus resultieren Ausscheidungen, die die Ätzung der Oxidschicht lokal maskieren. Die Ausdehnung dieser Oxidreste nach Durchätzung des Oxids kann zwischen 2 und 50 $\mu$m betragen, ihre Dicke ca. 25 % der Ausgangsdicke. Dies führt somit zu nicht weiter verwendbaren Scheiben.

Eine Möglichkeit, die Löslichkeit der Amine zu erhöhen, ist die Erhöhung der Ätztemperatur von üblicherweise Raumtemperatur auf etwa 40°C. Damit sind jedoch neue Nachteile verbunden, da durch die Temperaturerhöhung auch die Ätzrate vergrößert ist und somit die Anforderungen an die Bestimmung des Ätzendpunktes wachsen. Dies ist deshalb von Bedeutung, da die Ätzung nicht nur wie gewünscht vertikal zur Oberfläche abläuft, sondern auch lateral unter die maskierenden Fotolackschichten. Diese lateralen Ätzungen müssen so klein wie möglich gehalten werden.

Eine Herabsetzung der Ätzrate wäre zwar über eine Verminderung des Flußsäuregehalts möglich, damit würde aber auch eine Verminderung der Kapazität der Lösung einhergehen, so daß weniger Scheiben pro Badinhalt geätzt werden könnten und sich die zu neutralisierende Ammoniumfluoridmenge entsprechend vergrößern würde.

Aus alledem ergibt sich, daß die bisher bekannten Ätzlösungen nicht optimal sind und insbesondere primäre Amine als Additive nur eingeschränkt eingesetzt werden können.

Aufgabe der vorliegenden Erfindung ist es, die bekannten Ätzlösungen des Standes der Technik, die Ammoniumfluorid/ Flußsäure sowie primäre Amine als Additive enthalten so zu verbessern, daß sie ohne Einschränkung eingesetzt werden können.

Diese Aufgabe wird gelöst durch eine wäßrige Ätzlösung, die Ammoniumfluorid, Flußsäure sowie ein oder mehrere primäre aliphatische Amine mit einer Kettenlänge von 6 bis 18 Kohlenstoffatomen enthält, dadurch gekennzeichnet, daß Ammoniumfluorid in Mengen von 0,1 bis 17,5 Gew.%, Flußsäure in Mengen von 0,1 bis 10 Gew.% und Amin in Mengen von mindestens 10 ppm enthalten sind unter der Voraussetzung, daß Ammoniumfluorid im Überschuß gegenüber Flußsäure vorliegt.

Die erfindungsgemäße Ätzlösung enthält bevorzugt Ammoniumfluorid in Mengen von 10 bis 17 Gew.%, Flußsäure in Mengen von 3 bis 7 Gew.% und Amine in Mengen von 100 bis 500 ppm.

Eine besonders bevorzugte Ätzlösung enthält 15% Ammoniumfluorid, 5% Flußsäure und 400 ppm Amin.

Die primären aliphatischen Amine haben bevorzugt eine Kettenlänge von 8 bis 12 Kohlenstoffatomen. Besonders bevorzugte primäre aliphatische Amine sind Nonylamin und Heptylamin.

Die erfindungsgemäßen Ätzlösungen können in einfacher Weise durch Mischen der Bestandteile hergestellt werden, wobei die primären aliphatischen Amine auch in Form ihrer Hydrofluoride eingesetzt werden können.

Die erfindungsgemäßen Ätzlösungen können ohne Einschränkung in Halbleiterherstellungsprozessen zur Ätzung von Siliziumoxidschichten oder fotolackbeschichteten Siliziumoxidschichten eingesetzt werden, und zwar sowohl in Bad- als auch in Sprühprozessen.

Im Vergleich zu den Ätzlösungen des Standes der Technik ist die Ätzkapazität der erfindungsgemäßen Ätzlösungen bei gleicher Ätzrate erhalten geblieben. Damit weisen diese die gleichen positiven Eigenschaften wie die bekannten Lösungen auf, zeichnen sich darüberhinaus aber durch weitere wesentliche Vorteile aus. Beispielsweise ist durch den geringeren Ammoniumfluoridgehalt der Neutralisationsaufwand geringer, d.h. der Einsatz der erfindungsgemäßen Ätzlösungen ist umweltfreundlicher. Durch die wesentlich verbesserte Löslichkeit der primären aliphatischen Amine in dem System kommt es zu keinerlei Abscheidungen während des Ätzvorgangs.

Die Oberflächenspannung liegt unter 30 mN/m, und die Zahl der nach dem Durchätzen der Oberfläche auf diesem abgeschiedenen Partikel ist vermindert.

Die erfindungsgemäßen Ätzlösungen führen beim Einbringen des Wafers zum sofortigen Ablösen der Lufteinschlüsse in den feinen Strukturen. Wegen der daraus resultierenden großen Homogenität des Ätzvorgangs kann die Ätzzeit verringert werden, so daß Überätzung und unerwünschte laterale Ätzung auf ein Minimum reduziert werden können.

Beispiel

Eine Siliziumoxidschicht wurde mit einer Ätzlösung aus 15% Ammoniumfluorid, 5,2% Flußsäure und 400 ppm Nonylamin geätzt.

Die Oberflächenspannung dieser Lösung ist stark herabgesetzt und das Benetzungsverhalten ist hervorragend. Es resultiert eine Ätzung gewünschter Qualität.

Vergleichsbeispiel

Die Ätzung des Beispiels wird wiederholt mit einer Ätzlösung des Standes der Technik aus 35% Ammoniumfluorid, 6% Flußsäure und 400 ppm Nonylamin. Die Oberflächenspannung dieser Lösung ist zwar ebenfalls herabgesetzt und das Benetzungsverhalten ist ebenfalls hervorragend. Netzmittelausscheidungen führen aber in der Grenzschicht zur Maskierung des Oxids, das damit dort nicht geätzt wird. Diese ungleichmäßige Ätzung führt dazu, daß das Ätzprodukt nicht die gewünschte Qualität aufweist und nicht weiterverarbeitet werden kann.

**Patentansprüche**

1. Wäßrige Ätzlösung, die Ammoniumfluorid, Flußsäure sowie ein oder mehrere primäre aliphatische Amine mit einer Kettenlänge von 6 bis 18 Kohlenstoffatomen enthält, dadurch gekennzeichnet, daß Ammoniumfluorid in Mengen von 0,1 bis 17,5 Gew.%, Flußsäure in Mengen von 0,1 bis 10 Gew.% und Amin in Mengen von mindestens 10 ppm enthalten sind unter der Voraussetzung, daß Ammoniumfluorid im Überschuß gegenüber Flußsäure vorliegt.

2. Ätzlösung gemäß Anspruch 1, dadurch gekennzeichnet, daß sie Ammoniumfluorid in Mengen von 10 bis 17 Gew.%, Flußsäure in Mengen von 3 bis 7 Gew.% und Amine in Mengen von 100 bis 500 ppm enthält.

3. Ätzlösung gemäß Anspruch 1 und/oder 2, dadurch gekennzeichnet, daß als primäres aliphatisches Amin Nonylamin und/oder Heptylamin eingesetzt werden.

4. Verwendung der Ätzlösung der Ansprüche 1 bis 3 zur Ätzung von Siliziumoxidschichten oder fotolackbeschichteten Siliziumoxidschichten.